# EUROPEAN PATENT APPLICATION

(11) **EP 4 576 223 A1**
(43) Date of publication of application: **25.06.2025**
(21) Application number: 23854091.8
(22) Date of filing: 26.06.2023
(51) Int. Cl.: H01L 29/417, H01L 29/739

(54) **REVERSE CONDUCTING IGBT POWER DEVICE AND PREPARATION METHOD THEREFOR, AND ELECTRONIC DEVICE**

(30) Priority: 19.08.2022 CN 202210999420
(71) Applicant: BYD Company Limited, Shenzhen, Guangdong 518118 (CN)
(72) Inventor: CHANG, Le, Shenzhen, Guangdong 518118 (CN); XU, Yuanbo, Shenzhen, Guangdong 518118 (CN); LU, Hanhan, Shenzhen, Guangdong 518118 (CN)
(74) Representative: Mathys & Squire
(86) International application number: PCT/CN2023/102381
(87) International publication number: WO 2024/037186

(57) **Abstract**

Provided in the present application is an electronic device, comprising a reverse conducting IGBT power device. Further provided in the present application is a preparation method for a reverse conducting IGBT power device. The reverse conducting IGBT power device comprises at least one cell, wherein the cell comprises a first-conductivity-type electric field region; a front surface structure is formed on a front surface of the electric field region, and a collector electrode structure is formed on a back surface of the electric field region; the collector electrode structure comprises a first-conductivity-type first collector electrode layer, a second-conductivity-type second collector electrode layer, a collector electrode insertion layer, a collector electrode interconnection portion and a collector electrode; and the collector electrode insertion layer is located in the electric field region, and the collector electrode insertion layer is connected to the second collector electrode layer by means of the collector electrode interconnection portion.

## Description

### CROSS-REFERENCE TO RELATED APPLICATIONS

The present disclosure claims priority to Chinese Patent Application No. 202210999420.X, entitled "REVERSE CONDUCTING IGBT POWER DEVICE AND METHOD FOR PREPARING SAME, AND ELECTRONIC DEVICE" and filed on August 19, 2022. The entire content of the above-referenced application is incorporated herein by reference.

### FIELD

The present disclosure relates to the field of semiconductor device technologies, and in particular, to a reverse conducting IGBT power device, a method for preparing the reverse conducting IGBT power device, and an electronic device having the reverse conducting IGBT power device.

### BACKGROUND

An insulated gate bipolar transistor (IGBT) not only has advantages of easy driving and simple control of a MOSFET device, but also has the advantages of reduced conduction voltage, large on-state current, and low power loss of a power transistor. Therefore, the IGBT shows great advantages among power electronic devices, and has become the key component of power devices.

When the power device IGBT is used in a power electronic system, an additional freewheeling diode (FWD) is usually required to ensure safety and stability of the system. The additional FWD increases the quantity of devices and requires packaging. In addition, the additional packaging increases the quantity of solder joints, thereby increasing production costs and affecting reliability of the devices.

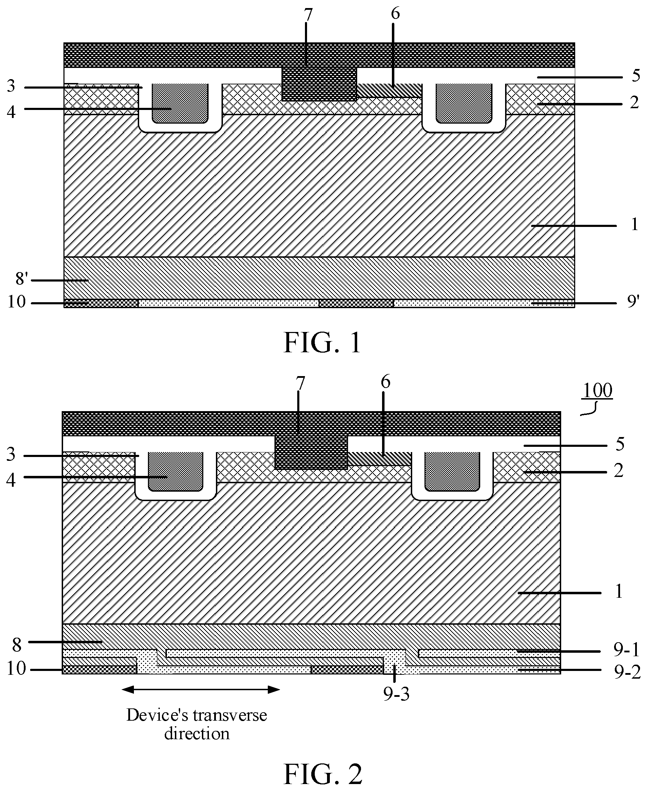

Currently, researchers have proposed an IGBT-diode integrated device, which is referred to as a reverse conducting IGBT (RC-IGBT). The device is implemented by introducing an N+ collector region on a collector region. A conventional reverse conducting IGBT power device, as shown in FIG. 1, is implemented by introducing an N+ collector region 8' on a collector region, where 9' is a P+ collector region. However, during forward conduction of the conventional reverse conducting IGBT structure, there is a voltage snapback, that is, a negative differential resistance effect. Currently, in some structures, the negative differential resistance effect is overcome by increasing the width of the P+ current collector region on the back side, and in some structures, a trench structure and a floating stop ring are arranged on the back side to reduce the voltage snapback phenomenon, thereby suppressing the negative differential resistance effect. However, in either case, other performance of the reverse conducting IGBT device is degraded. Therefore, to overcome the negative differential resistance phenomenon, the structure of the reverse conducting IGBT power device needs to be further improved.

### SUMMARY

The present disclosure is intended to resolve at least one of the technical problems in the related art to some extent.

Therefore, an embodiment of a first aspect of the present disclosure provides a reverse conducting IGBT power device, which can suppress a negative differential resistance effect.

An embodiment of a second aspect of the present disclosure further provides a method for preparing a reverse conducting IGBT power device.

An embodiment of a third aspect of the present disclosure further provides an electronic device having a reverse conducting IGBT power device.

To resolve the foregoing problem, the reverse conducting IGBT power device provided in this embodiment of the first aspect of the present disclosure includes at least one cell. The cell includes:

an electric field region of a first conductivity type. A front structure is formed on a front side of the electric field region, and a collector structure is arranged on a back side of the electric field region. The collector structure includes a first collector layer of the first conductivity type, a second collector layer of a second conductivity type, a collector insertion layer, a collector interconnection portion, and a collector. The second collector layer and the first collector layer are located on a lower surface of the electric field region, the second collector layer is in contact with the first collector layer, both the second collector layer and the first collector layer are connected to the collector, the collector insertion layer is located in the electric field region, and the collector insertion layer is connected to the second collector layer by the collector interconnection portion.

According to the reverse conducting IGBT power device in this embodiment of the present disclosure, the collector insertion layer is arranged in the electric field region, and the collector insertion layer is connected to the second collector layer by the collector interconnection portion, so that a length of the second collector layer in a transverse direction of the reverse conducting IGBT power device is increased. When the reverse conducting IGBT power device is conducted forward, a path for collecting electrons by the collector is extended, and a potential difference can be increased faster to meet a requirement for junction conduction between the second collector layer and the electric field region. A PN junction is conducted forward faster, and a voltage snapback is reduced, thereby suppressing a negative differential resistance effect. Other performance of the device is not degraded by the structure either.

To resolve the foregoing problem, the method for preparing a reverse conducting IGBT power device according to this embodiment of the second aspect of the present disclosure includes: A substrate is provided, where the substrate has an electric field region. A front structure is prepared through photolithography, oxidation, ion injection, and deposition on a front side of the electric field region. A first collector layer of a first conductivity type and a second collector layer of a second conductivity type are prepared through photolithography, ion injection, or epitaxy on a back side of the electric field region, and a collector insertion layer and a collector interconnection portion that are of the second conductivity type are prepared in the electric field region, where the collector insertion layer is electrically connected to the second collector layer by the collector interconnection portion. A metal electrode is prepared on lower surfaces of the first collector layer and the second collector layer to form a collector.

According to the method for preparing a reverse conducting IGBT power device in this embodiment of the present disclosure, the collector insertion layer is prepared in the electric field region, and the collector insertion layer is electrically connected to the second collector layer by the collector interconnection portion, so that a length of the second collector layer in a transverse direction of the reverse conducting IGBT power device is increased. When the reverse conducting IGBT power device is conducted forward, a path for collecting electrons by the collector is extended, and a potential difference can be increased faster to meet a requirement for junction conduction between the second collector layer and the electric field region. APN junction is conducted forward faster, and a voltage snapback is reduced, thereby suppressing a negative differential resistance effect. Other performance of the power device is not degraded.

To resolve the foregoing problem, the electronic device provided in this embodiment of the third aspect of the present disclosure includes at least one reverse conducting IGBT power device according to any embodiment of the first aspect of the present disclosure.

In the electronic device in this embodiment of the present disclosure, by using the reverse conducting IGBT power device in the foregoing embodiments, a voltage snapback phenomenon is reduced, a negative differential resistance effect can be effectively suppressed, and product performance is improved.

Other aspects and advantages of the present disclosure will be given in the following description, some of which will become apparent from the following description or may be learned from practices of the present disclosure.

### BRIEF DESCRIPTION OF THE DRAWINGS

The foregoing and/or additional aspects and advantages of the present disclosure will become apparent and comprehensible in the description made with reference to the following accompanying drawings, where:
FIG. 1 is a schematic diagram of a structure of a conventional reverse conducting IGBT power device;
FIG. 2 is a schematic diagram of a structure of a cell of a reverse conducting IGBT power device according to an embodiment of the present disclosure;
FIG. 3 is a flowchart of a method for preparing a reverse conducting IGBT power device according to an embodiment of the present disclosure;
FIG. 4 to FIG. 7 are schematic diagrams of corresponding structures formed according to preparation steps of Embodiment 1 of the present disclosure;
FIG. 8 to FIG. 10 are schematic diagrams of corresponding structures formed according to preparation steps of Embodiment 2 of the present disclosure;
FIG. 11 is a schematic diagram of simulated forward conduction characteristic curves of a conventional reverse conducting IGBT power device according to an embodiment of the present disclosure and a reverse conducting IGBT power device according to Embodiment 1; and
FIG. 12 is a schematic block diagram of an electronic device according to an embodiment of the present disclosure.

### In the drawings:

### Related art:

N+ collector region 8' and P+ collector region 9'; and
The present disclosure:
reverse conducting IGBT power device 100; electronic device 1000; front side 1011;
drift region 1, active region 2, gate oxide layer 3, polysilicon gate 4, dielectric layer 5, emitter region 6, emitter 7, field-stop layer 8-1, field-stop layer 8-2, collector insertion layer 9-1, second collector layer 9-2, collector interconnection portion 9-3, and first collector layer 10.

### DETAILED DESCRIPTION

The following describes embodiments of the present disclosure in detail. Examples of the embodiments are shown in the accompanying drawings, and same or similar reference signs in all the accompanying drawings indicate same or similar components or components having same or similar functions. The embodiments described below with reference to the accompanying drawings are exemplary, and are intended to explain the present disclosure and cannot be construed as a limitation to the present disclosure.

The following describes a reverse conducting IGBT power device according to an embodiment of a first aspect of the present disclosure with reference to the accompanying drawings.

The reverse conducting IGBT power device in this embodiment of the present disclosure includes at least one cell. FIG. 2 is a schematic diagram of a structure of a cell of a reverse conducting IGBT power device according to an embodiment of the present disclosure.

In this embodiment of the present disclosure, a cell of the reverse conducting IGBT power device 100 includes an electric field region 101 of a first conductivity type. A front structure is formed on a front side 1011 of the electric field region 101. As shown in FIG. 2, the front structure may include an emitter 7, an emitter region 6, an active region 2, and a gate structure (3 and 4). The emitter 7 is in ohmic contact with both the emitter region 6 and the active region 2, and the gate structure (3 and 4) is insulated from the emitter 7, the emitter region 6, the active region 2, and the electric field region 101 (for example, insulated by a dielectric layer 5). A collector structure is arranged on a back side of the electric field region 101.

In some embodiments, the electric field region 101 may be a drift region 1. Alternatively, as shown in FIG. 2, the electric field region 101 includes a drift region 1 and a field-stop layer 8 (or referred to as a buffer layer), and the field-stop layer 8 is in contact with a lower surface of the drift region 1. That is, the reverse conducting IGBT power device 100 in this embodiment of the present disclosure may be of a punch-through structure or a non-punch-through structure. The electric field region may be of a non-punch-through (NPT) structure, a punch-through (PT) structure, a soft punch-through (SPT) structure, or a field-stop (FS) structure, which is not specifically limited.

In this embodiment, the gate structure may be a trench gate structure, as shown in FIG. 2. The trench gate structure includes a gate groove of the drift region 1. A polysilicon gate 4 and a gate oxide layer 3 are arranged in the gate groove, and the polysilicon gate 4 is insulated from other structures by the dielectric layer 5. In some embodiments, a dielectric material of the dielectric layer 5 may be a high-k dielectric material such as SiO₂, HfO₂, Al₂O₃, or Si₃N₄. The gate structure may alternatively be a planar gate structure, which is not specifically limited herein.

As shown in FIG. 2, different from a structure of the existing reverse conducting IGBT power device, a collector structure of the reverse conducting IGBT power device 100 in this embodiment of the present disclosure includes a first collector layer 10 of a first conductivity type, a second collector layer 9-2 of a second conductivity type, a collector insertion layer 9-1 (only one layer is shown in FIG. 2 as an example), a collector interconnection portion 9-3, and a collector (not shown). The second collector layer 9-2 and the first collector layer 10 are located on a lower surface of the electric field region 101, for example, a lower surface of the drift region or the field-stop region. The second collector layer 9-2 is in contact with the first collector layer 10. Both the second collector layer 9-2 and the first collector layer 10 are connected to the collector. The collector insertion layer 9-1 is located in the electric field region 101, for example, in the drift region 1 or the field-stop layer 8. The collector insertion layer 9-1 is connected to the second collector layer 9-2 by the collector interconnection portion 9-3, that is, the collector is connected.

In some embodiments of the present disclosure, For the punch-through structure, the electric field region 101 is a drift region 1, and the collector insertion layer 9-1 is arranged in the drift region 1; and for the non-punch-through structure, the electric field region 101 includes the drift region 1 and the field-stop layer 8 (or referred to as a buffer layer), and the collector insertion layer 9-1 is arranged in the field-stop layer 8, as shown in FIG. 2.

In this embodiment, the first conductivity type may be N-type, and the second conductivity type is P-type; or the first conductivity type may be P-type, and the second conductivity type is N-type. The collector structure in this embodiment of the present disclosure is applicable to an N-channel reverse conducting IGBT power device, and is also applicable to a P-channel reverse conducting IGBT power device. For ease of description, an N-channel reverse conducting IGBT power device is used as an example in the embodiments of the present disclosure, the first conductivity type is N-type, and the second conductivity type is P-type.

As shown in FIG. 2, the electric field region 101 includes an N-drift region 1 and an N-type field-stop layer 8. The collector structure includes an N+ first collector layer 10 and a P+ collector layer. The P+ collector layer may be a double-layer or multi-layer interconnection structure. The P+ collector layer includes a P+ collector insertion layer 9-1. There may be one or more collector insertion layers 9-1 (one layer is shown in FIG. 2), and the collector insertion layer 9-1 is connected to the second collector layer 9-2 by the P+ collector interconnection portion 9-3, which is equivalent to extending a length of the P+ collector layer in a transverse direction of the power device.

When the power device is conducted forward, an electron path passes from the drift region 1 to the field-stop layer 8, and then reaches the first collector such as the N+ first collector layer 10 by transversely bypassing the collector insertion layer 9-1, which is equivalent to prolonging a path for collecting electrons by the collector. A potential difference can be increased faster to meet a requirement for junction conduction between the second collector layer 9-2 and the electric field region such as the drift region 1 or the field-stop layer 8, and switching to an IGBT mode faster can be made, thereby reducing a voltage snapback, and suppressing a negative differential resistance effect.

In the reverse conducting IGBT power device 100 in this embodiment of the present disclosure, the collector insertion layer 9-1 is arranged in the electric field region, and the collector insertion layer 9-1 is connected to the second collector layer 9-2 by the collector interconnection portion 9-3, so that a length of the second collector layer 9-2 in a transverse direction of the power device is extended. When the reverse conducting IGBT power device 100 is conducted forward, an electron path needs to transversely bypass the collector insertion layer 9-1 to reach the first collector such as the N+ first collector layer 10, which is equivalent to prolonging a path for collecting electrons by the collector. A potential difference can be increased faster to meet a requirement for junction conduction between the second collector layer 9-2 and the electric field region, and the PN junction is conducted forward faster, thereby reducing a voltage snapback and suppressing a negative differential resistance effect. The structure does not degrade other performance of the device either.

In some embodiments of the present disclosure, the semiconductor power device includes a plurality of cells arranged in a transverse direction of the power device, and collector insertion layers 9-1 and second collector layers 9-2 of two adjacent cells overlap in a longitudinal direction of the power device, as shown in FIG. 2. In this way, a length of the P+ collector layer in the transverse direction of the power device can be increased, a negative differential resistance effect is effectively suppressed, and overall distribution of the second collector layers 9-2 is not affected. Certainly, the collector insertion layers and the second collector layers may alternatively not overlap. To be specific, the second collector layer 9-2, the collector insertion layer 9-1, and the collector interconnection portion 9-3 of each cell form a collector interconnection structure, and collector interconnection structures of two adjacent cells are distributed in parallel in a transverse direction of the power device. That is, the collector insertion layers 9-1 and the second collector layers 9-2 do not overlap.

In some embodiments, the collector structure includes a plurality of collector insertion layers 9-1, that is, there may be a plurality of collector insertion layers 9-1. The plurality of collector insertion layers 9-1 are arranged in the longitudinal direction of the power device, and each collector insertion layer 9-1 is connected to the second collector layer 9-2 by the collector interconnection portion 9-3. Lengths of the plurality of collector insertion layers 9-1 in the transverse direction of the power device may vary, so that a length of the second collector layer 9-2 can be further increased, and the negative differential resistance effect can be effectively suppressed.

In some embodiments, there may alternatively be one collector insertion layer 9-1, and there is a preset distance between the collector insertion layer 9-1 and the second collector layer 9-2, for example, 2.5 micrometers to 3.5 micrometers. The collector insertion layer 9-1 is connected to the second collector layer 9-2 by the collector interconnection portion 9-3. One end of the collector interconnection portion 9-3 is connected to an end portion or a middle portion of the collector insertion layer 9-1, and the other end of the collector interconnection portion 9-3 is connected to an end portion or a middle portion of the second collector layer 9-2. For example, one end of the collector interconnection portion 9-3 is connected to the middle portion of the collector insertion layer 9-1 and the other end of the collector interconnection portion 9-3 is connected to the middle portion of the second collector layer 9-2, or one end of the collector interconnection portion 9-3 is connected to one end of the collector insertion layer 9-1 and the other end of the collector interconnection portion 9-3 is connected to the middle portion of the second collector layer 9-2, or one end of the collector interconnection portion 9-3 is connected to the middle portion of the collector insertion layer 9-1 and the other end of the collector interconnection portion 9-3 is connected to one end of the second collector layer 9-2. As shown in FIG. 2, the collector interconnection portion 9-3 is connected to one end of the collector insertion layer 9-1, and the collector interconnection portion 9-3 is connected to one end of the second collector layer 9-2, so that a length of the P+ collector layer in the transverse direction of the power device can be increased, an electron path of the collector can be extended, and a negative differential resistance effect can be effectively suppressed.

The structure of the reverse conducting IGBT power device 100 in this embodiment of the present disclosure is described above. In the reverse conducting IGBT power device 100 in this embodiment of the present disclosure, the collector interconnection structure of the collector insertion layer 9-1, the collector interconnection portion 9-3, and the second collector 9-2 is arranged, so that a length of the second collector in the transverse direction of the power device is increased, an electron path is extended, and a negative differential resistance effect can be effectively suppressed.

In some examples of the present disclosure, the front structure and the back-side structure may be prepared through processes such as photolithography, epitaxy, oxidation, ion injection, and deposition on a substrate made of a semiconductor material such as Si, SiC, GaAs, or GaN. A method for preparing the reverse conducting IGBT power device in the embodiments of the present disclosure is described below.

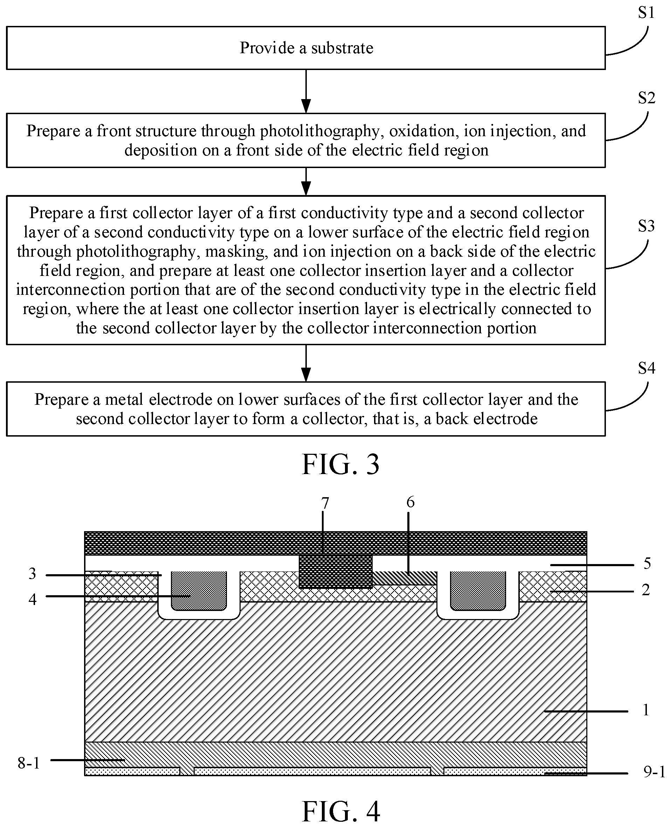

FIG. 3 is a flowchart of a method for preparing a reverse conducting IGBT power device according to an embodiment of the present disclosure. As shown in FIG. 3, the method includes:
S1: A substrate is provided.

The substrate has an electric field region. In some embodiments, the electric field region may be a drift region, that is, a punch-through structure is used. Alternatively, the electric field region may include a drift region and a field-stop region (or referred to as a buffer region), that is, a non-punch-through structure is used.

In this embodiment, an original substrate may be provided, and a drift region of the first conductivity type is formed on a front side of the original substrate, where the drift region is the electric field region. That is, the drift region is prepared on the front side of the original substrate before a front structure and a back side structure are prepared. Certainly, for a non-punch-through structure, the field-stop layer may also be prepared through ion injection in a subsequent preparation step.

Alternatively, an original substrate is provided, a drift region of the first conductivity type is formed on a front side of the original substrate, and forming a field-stop layer of the first conductivity type on a back side of the original substrate, where the drift region and the field-stop layer are the electric field region. That is, the drift region is prepared on the front side of the original substrate and the field-stop region is prepared on the back side before a front structure and a back side structure are prepared.

Alternatively, a substrate having a drift region of the first conductivity type and a field-stop layer of the first conductivity type are directly provided, where the drift region and the field-stop layer are the electric field region. For example, a double-layer epitaxial material having an N-type field-stop layer and an N-drift region may be directly selected as a silicon wafer material for the start of a process, that is, an original substrate. Therefore, an FS field-stop layer formed through ion injection is not required in a subsequent process.

In some embodiments, the original substrate may be made of Si, SiC, GaAs, or GaN.

S2: A front structure is prepared through photolithography, oxidation, ion injection, and deposition on a front side of the electric field region.

In some embodiments, the front structure may include at least an emitter, an emitter region, an active region, and a gate structure. The emitter is in ohmic contact with both the emitter region and the active region, and the gate structure is insulated from the emitter, the emitter region, and the active region.

S3: A first collector layer of a first conductivity type and a second collector layer of a second conductivity type are prepared on a lower surface of the electric field region through photolithography, ion injection, and epitaxy on a back side of the electric field region, and a collector insertion layer and a collector interconnection portion that are of the second conductivity type are prepared in the electric field region, where the collector insertion layer is electrically connected to the second collector layer by the collector interconnection portion.

In this embodiment, For the punch-through structure, the front structure is prepared above the drift region, the collector insertion layer is prepared in the drift region, and the collector interconnection portion and the second collector layer are prepared through ion injection, so that the collector insertion layer is connected to the second collector layer.

S4: A metal electrode is prepared on lower surfaces of the first collector layer and the second collector layer to form a collector, that is, a back electrode.

According to the method for preparing a reverse conducting IGBT power device in this embodiment of the present disclosure, the collector insertion layer is prepared in the electric field region, and the collector insertion layer is electrically connected to the second collector layer by the collector interconnection portion, so that a length of the second collector layer in a transverse direction of the power device is increased. When the reverse conducting IGBT power device is conducted forward, a path for collecting electrons by the collector is extended, and a potential difference can be increased faster to meet a requirement for junction conduction between the second collector layer and the electric field region. A PN junction is conducted forward faster, and a voltage snapback is reduced, thereby suppressing a negative differential resistance effect. Other performance of the power device is not degraded.

In some embodiments, the collector structure may be prepared by using an epitaxial layer. Specifically, a mask of the collector insertion layer is prepared through photolithography on the back side of the electric field region, and the collector insertion layer of the second conductivity type is formed through ion injection; an epitaxial layer of a same doping type as that of the electric field region is formed through epitaxy on a lower surface of the substrate on which the collector insertion layer is prepared; the second collector layer of the second conductivity type is formed through ion injection on the epitaxial layer, and the collector interconnection portion of the second conductivity type is formed through ion injection to connect the second collector layer and the collector insertion layer; and photolithography, ion injection, and epitaxy are performed on the second collector layer to prepare the first collector layer of the first conductivity type in contact with the epitaxial layer and the second collector layer.

The method for preparing a reverse conducting IGBT power device in this embodiment of the present disclosure is described below by using an N-channel non-punch-through structure such as an FS-type structure as an example.

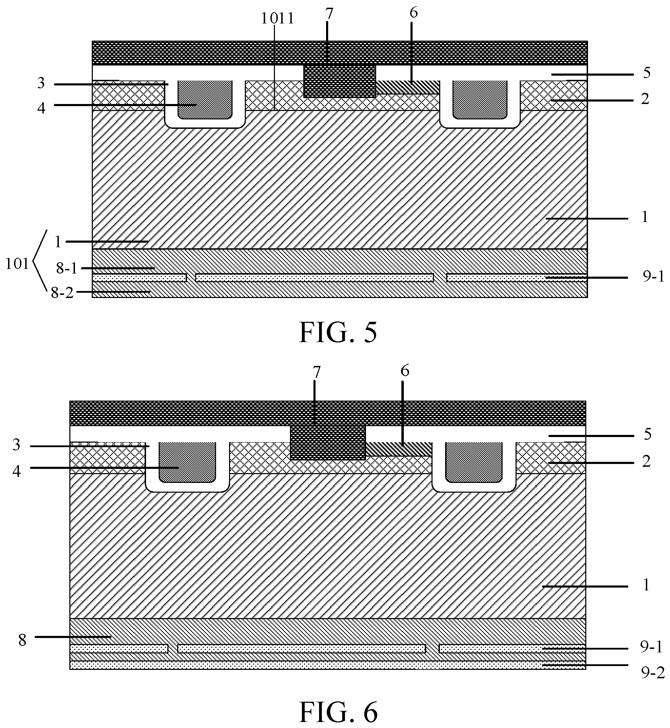

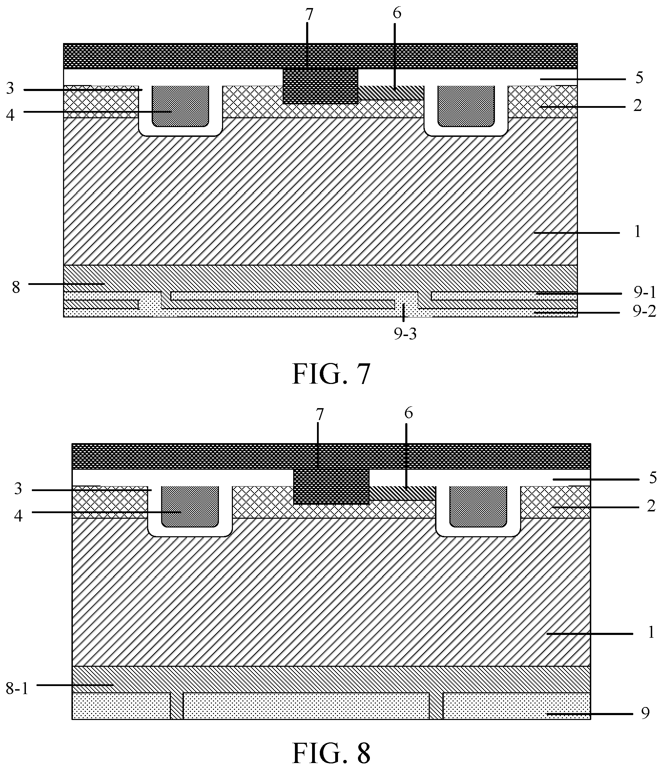

Embodiment 1: A trench-type FS reverse conducting IGBT power device with a voltage level of 750 V is used as an example, and a structure of a cell thereof is shown in FIG. 2. Referring to FIG. 4 to FIG. 7, a method for preparing the same includes the following steps:
First step: As shown in FIG. 4, an N-type silicon substrate with a thickness ranging from 300 micrometers to 500 micrometers is selected, and the substrate is lightly doped to form an N-drift region 1; and an emitter 7, an emitter region 6, an active region 2, and a gate structure (3 and 4) in a cell of the reverse conducting IGBT power device are prepared on a front side of the silicon substrate through a plurality of photolithography, oxidation, ion injection, annealing, and deposition processes above the drift region 1, and insulation treatment is performed through a dielectric layer 5. A specific process for the gate structure being a trench gate structure is a trench gate structure process.
Second step: The silicon substrate is flipped, and a back side of a silicon wafer is thinned, to cause a thickness of the silicon wafer to range from 70 micrometers to 80 micrometers, for example, 77 micrometers.
Third step: As shown in FIG. 4, photolithography is performed, a P+ mask is prepared in a partial region of the back side of the substrate, and a P+ collector insertion layer 9-1 is prepared on the back side through ion injection. A thickness of the formed collector insertion layer 9-1 may be 0.2 micrometers, an ion injection energy is 40 KeV, and an injection dose is 2 × 10¹³/cm².
Fourth step: As shown in FIG. 5, 3 micrometers of N-type silicon 8-2 with the same dopant as that of the substrate is deposited on the back side.
Fifth step: As shown in FIG. 6, a P+ second collector layer 9-2 connected to a metal electrode, that is, a collector, is prepared on the back side through ion injection. A thickness of the formed second collector layer 9-2 is 0.2 micrometers. An ion injection energy may be 40 KeV, and an injection dose may be 2 × 10¹³/cm².
Sixth step: As shown in FIG. 7, photolithography is performed, a mask of a P+ collector interconnection portion 9-3 is prepared on the back side, and the P+ collector insertion layer 9-1 and the P+ second collector layer 9-2 are connected through ion injection, to form an interconnected P+ collector region.
Seventh step: As shown in FIG. 2, photolithography is performed, a mask of an N+ first collector layer 10 is prepared on the back side, and the N+ first collector layer 10 is prepared on the back side through ion injection. A thickness of the formed N+ first collector layer 10 is 0.2 micrometers, an ion injection energy is 40 KeV, and an injection dose is 2 × 10¹³/cm².
Eighth step: Field-stop layers including a field-stop layer 8-1 and a field-stop layer 8-2 are formed on the back side of the cell through ion injection.
Ninth step: Metal is deposited on the back side to form a metal collector, that is, a back electrode.

A trench-type FS reverse conducting IGBT power device having an overlapping P+ collector interconnection structure shown in FIG. 2 can be prepared through the foregoing preparing method. It may be understood that the process steps and the process conditions in the foregoing preparation method may be set according to an actual requirement, and a sequence of the process steps may also be adjusted or changed based on the actual requirement.

In some other embodiments of the present disclosure, the reverse conducting IGBT power device in this embodiment of the present disclosure may alternatively be prepared without forming an epitaxial layer through epitaxy, and may alternatively be prepared through deep ion injection.

Specifically, an injection layer of the second conductivity type is formed through photolithography and ion injection on the back side of the electric field region, and photolithography, masking, and ion injection are performed on the injection layer to form the collector insertion layer inside the electric field region and form the collector interconnection portion connected to the collector insertion layer; the second collector layer of the second conductivity type is prepared through ion injection on a surface of the back side of the electric field region in which the collector insertion layer and the collector interconnection portion are formed, where the second collector layer is connected to the collector interconnection portion; and the first collector layer of the first conductivity type is formed through photolithography and ion injection on the second collector layer.

The method for preparing a reverse conducting IGBT power device in this embodiment of the present disclosure is described below by still using an N-channel non-punch-through structure such as an FS-type structure as an example.

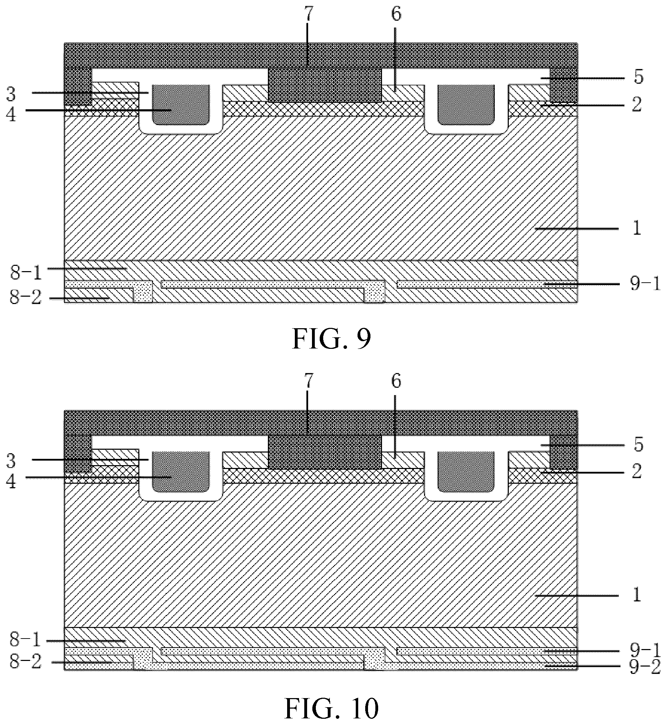

Embodiment 2: Similarly, a FS reverse conducting IGBT power device with a voltage level of 750 V is used as an example, and a structure of a cell thereof is shown in FIG. 2. A difference is that epitaxy is not performed on deposited silicon on a back side in this embodiment. Referring to FIG. 8 to FIG. 10, a method for preparing the same includes the following steps:
First step: As shown in FIG. 8, an N-type silicon substrate with a thickness ranging from 300 micrometers to 500 micrometers is selected, and the substrate is lightly doped to form an N-drift region 1; and an emitter 7, an emitter region 6, an active region 2, and a gate structure (3 and 4) in a cell of the reverse conducting IGBT power device are prepared on a front side of the silicon wafer through a plurality of photolithography, oxidation, ion injection, annealing, and deposition processes above the drift region 1, and insulation treatment is performed through a dielectric layer 5. A specific process for the gate structure being a trench gate structure is a trench gate structure process.
Second step: The silicon substrate is flipped, a back side of a silicon wafer is thinned, to cause a thickness of the silicon wafer to range, for example, from 70 micrometers to 80 micrometers, and an N-field-stop layer 8-1 is formed on the back side of the substrate through hydrogen injection.
Third step: As shown in FIG. 8, photolithography is performed, a mask of a P+ collector insertion layer is prepared, and an injection layer 9 is prepared through ion injection.
Fourth step: As shown in FIG. 9, photolithography is performed on the injection layer 9, a mask of an N-field-stop layer 8-2 is prepared, the N-field-stop layer 8-2 with the same dopant as that of the N-field-stop layer 8-1 is prepared through ion injection, and a P+ collector insertion layer 9-1 and a P+ collector interconnection portion 9-3 connected to the P+ collector insertion layer 9-1 are formed. The P+ collector insertion layer 9-1 is deep.
Fifth step: As shown in FIG. 10, a P+ second collector layer 9-2 connected to a metal collector is prepared through ion injection.
Sixth step: As shown in FIG. 2, a mask of an N+ first collector layer 10 is prepared through photolithography, and the N+ second collector 10 is prepared through ion injection.
Seventh step: Metal is deposited on the back side to form a metal collector, that is, a back electrode.

A trench-type FS reverse conducting IGBT power device having an overlapping P+ collector interconnection structure shown in FIG. 2 can be prepared through the foregoing preparing method. It may be understood that the process steps and the process conditions in the foregoing preparation method may be set according to an actual requirement, and a sequence of the process steps may also be adjusted or changed based on the actual requirement.

A simulation test is performed based on Embodiment 1. Specifically, two structures of the conventional reverse conducting IGBT power device and the reverse conducting IGBT power device in Embodiment 1 are designed through simulation. The two structures have identical front-side emitters, emitter regions, and gate structures. An N+ first collector layer and a P+ second collector layer in a back-side collector region that are in contact with a metal collector have a same width. A width of the N+ first collector layer is 3 micrometers, and a width of the P+ second collector layer is 19.2 micrometers. The P+ collector insertion layer 9-1 and the P+ second collector layer 9-2 in this embodiment of the present disclosure are spaced apart by 3 micrometers.

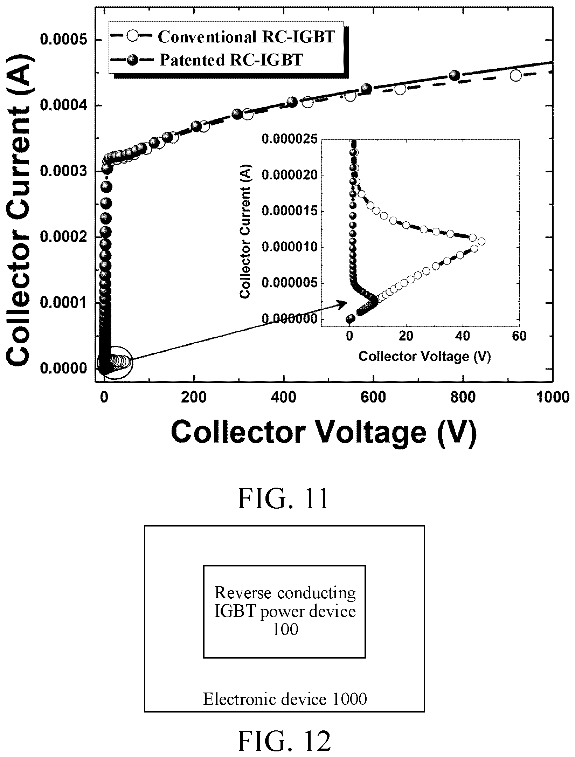

FIG. 11 is a schematic diagram of forward conduction characteristic curves obtained through simulation of a conventional reverse conducting IGBT power device and a reverse conducting IGBT power device according to Embodiment 1. The accompanying drawing shows an enlarged view at the beginning of conduction of the power devices. It can be seen that the negative differential resistance phenomenon of the conventional reverse conducting IGBT power device reaches 48 V, while the negative differential resistance phenomenon of the reverse conducting IGBT power device obtained in Embodiment 1 of the present disclosure is 9 V, which reduces the negative differential resistance effect by more than 80%, and effectively suppresses the negative differential resistance effect.

An embodiment of a third aspect of the present disclosure further provides an electronic device 1000. As shown in FIG. 12, the electronic device 1000 includes at least one reverse conducting IGBT power device 100 according to any embodiment of the first aspect of the present disclosure. The electronic device 1000 may be a motor controller, an on-board charger, or the like. The reverse conducting IGBT power device 100 is configured to drive, convert an electrical signal, or the like.

In the electronic device 1000 in this embodiment of the present disclosure, by using the reverse conducting IGBT power device in the foregoing embodiments, a voltage snapback phenomenon is reduced, a negative differential resistance effect can be effectively suppressed, and product performance is improved.

The foregoing descriptions are merely two specific implementations of the present disclosure, and any feature disclosed in this specification may be replaced with another equivalent or replaceable feature having a similar purpose. All disclosed features, or steps in all disclosed methods or processes can be combined in any mode except for the mutually exclusive features or steps.

In description of the present disclosure, description of reference terms such as "one embodiment", "some embodiments", "example", "specific example", or "some examples" means including specific features, structures, materials, or features described in the embodiment or example in at least one embodiment or example of the present disclosure. In this specification, exemplary description of the foregoing terms does not necessarily refer to a same embodiment or example. Moreover, the specific feature, structure, material, or characteristic described may be combined in any one or more embodiments or examples in a suitable manner. In addition, with no conflict, a person skilled in the art may integrate or combine different embodiments or examples described in the specification and features of the different embodiments or examples.

Although the embodiments of the present disclosure are shown and described above, it can be understood that, the foregoing embodiments are exemplary, and cannot be construed as a limitation to the present disclosure. Within the scope of the present disclosure, a person of ordinary skill in the art may make changes, modifications, replacement, and variations to the foregoing embodiments.

## Claims

1. A reverse conducting IGBT power device (100), the reverse conducting IGBT power device (100) comprising at least one cell, and the cell comprising:
an electric field region (101) of a first conductivity type, a front structure being formed on a front side (1011) of the electric field region (101), and a collector structure being arranged on a back side of the electric field region (101);
wherein the collector structure comprises:
a first collector layer (10) of the first conductivity type;
a second collector layer (9-2) of a second conductivity type;
a collector insertion layer (9-1);
a collector interconnection portion (9-3); and
a collector, the second collector layer (9-2) and the first collector layer (10) being located on a lower surface of the electric field region (101), the second collector layer (9-2) being in contact with the first collector layer (10), both the second collector layer (9-2) and the first collector layer (10) being connected to the collector, the collector insertion layer (9-1) being located in the electric field region (101), and the collector insertion layer (9-1) being connected to the second collector layer (9-2) by the collector interconnection portion (9-3).

2. The reverse conducting IGBT power device (100) according to claim 1, wherein the electric field region (101) is a drift region (1), and the collector insertion layer (9-1) is arranged in the drift region (1).

3. The reverse conducting IGBT power device (100) according to claim 1, wherein the electric field region (101) comprises:
a drift region (1); and
a field-stop layer (8), wherein the field-stop layer (8) is in contact with a lower surface of the drift region (1), and the collector insertion layer (9-1) is arranged in the field-stop layer (8).

4. The reverse conducting IGBT power device (100) according to any one of claims 1 to 3, the reverse conducting IGBT power device (100) comprising a plurality of cells arranged in a transverse direction of the reverse conducting IGBT power device (100), and collector insertion layers (9-1) and second collector layers (9-2) of two adjacent cells overlap in the transverse direction of the reverse conducting IGBT power device (100).

5. The reverse conducting IGBT power device (100) according to any one of claims 1 to 3, the reverse conducting IGBT power device (100) comprising a plurality of cells arranged in a transverse direction of the reverse conducting IGBT power device (100); and
the second collector layer (9-2), the collector insertion layer (9-1), and the collector interconnection portion (9-3) of each of the cells form a collector interconnection structure, and collector interconnection structures of two adjacent cells are distributed in parallel in a transverse direction of the reverse conducting IGBT power device (100).

6. The reverse conducting IGBT power device (100) according to any one of claims 1 to 5, wherein the collector structure comprises a plurality of collector insertion layers (9-1), the plurality of collector insertion layers (9-1) are arranged in a longitudinal direction of the reverse conducting IGBT power device (100), and each of the collector insertion layers (9-1) is connected to the second collector layer (9-2) by the collector interconnection portion (9-3).

7. The reverse conducting IGBT power device (100) according to any one of claims 1 to 6, wherein a preset distance is provided between the collector insertion layer (9-1) and the second collector layer (9-2), one end of the collector interconnection portion (9-3) is connected to an end portion or a middle portion of the collector insertion layer (9-1), and the other end of the collector interconnection portion (9-3) is connected to an end portion or a middle portion of the second collector layer (9-2).

8. The reverse conducting IGBT power device (100) according to claim 7, wherein the preset distance is in a range of 2.5 micrometers to 3.5 micrometers.

9. The reverse conducting IGBT power device (100) according to any one of claims 1 to 8, wherein
the first conductivity type is N-type, and the second conductivity type is P-type; or
the first conductivity type is P-type, and the second conductivity type is N-type.

10. A method for preparing a reverse conducting IGBT power device, comprising:
providing a substrate, wherein the substrate has an electric field region;
preparing a front structure through photolithography, oxidation, ion injection, and deposition on a front side of the electric field region;
preparing a first collector layer of a first conductivity type and a second collector layer of a second conductivity type on a lower surface of the electric field region through photolithography, ion injection, and epitaxy on a back side of the electric field region, and preparing a collector insertion layer and a collector interconnection portion that are of the second conductivity type in the electric field region, wherein the collector insertion layer is electrically connected to the second collector layer by the collector interconnection portion; and
preparing a metal electrode on lower surfaces of the first collector layer and the second collector layer to form a collector.

11. The method for preparing a reverse conducting IGBT power device according to claim 10, wherein providing the substrate comprises:
providing an original substrate, and forming a drift region of the first conductivity type on a front side of the original substrate, wherein the drift region is the electric field region; or
providing an original substrate, forming a drift region of the first conductivity type on a front side of the original substrate, and forming a field-stop layer of the first conductivity type on a back side of the original substrate, wherein the drift region and the field-stop layer are the electric field region; or
providing a substrate having a drift region of the first conductivity type and a field-stop layer of the first conductivity type, wherein the drift region and the field-stop layer are the electric field region.

12. The method for preparing a reverse conducting IGBT power device according to claim 11, wherein preparing the first collector layer of the first conductivity type, and the second collector layer, the collector insertion layer, and the collector interconnection portion that are of the second conductivity type through photolithography, ion injection, and epitaxy on the back side of the electric field region comprises:
preparing a mask of the collector insertion layer through photolithography on the back side of the electric field region, and forming the collector insertion layer of the second conductivity type through ion injection;
forming, through epitaxy, an epitaxial layer of a same doping type as that of the electric field region on a lower surface of the substrate on which the collector insertion layer is prepared;
forming the second collector layer of the second conductivity type through ion injection on the epitaxial layer, and forming the collector interconnection portion of the second conductivity type through ion injection to connect the second collector layer and the collector insertion layer; and
performing photolithography, ion injection, and epitaxy on the second collector layer to prepare the first collector layer of the first conductivity type that is in contact with the epitaxial layer and the second collector layer.

13. The method for preparing a reverse conducting IGBT power device according to claim 11, wherein preparing the first collector layer of the first conductivity type, and the second collector layer, the collector insertion layer, and the collector interconnection portion that are of the second conductivity type through photolithography and ion injection on the back side of the electric field region comprises:
forming an injection layer of the second conductivity type through photolithography and ion injection on the back side of the electric field region, and performing photolithography, masking, and ion injection on the injection layer to form the collector insertion layer inside the electric field region and form the collector interconnection portion connected to the collector insertion layer;
preparing the second collector layer of the second conductivity type through ion injection on a surface of the back side of the electric field region in which the collector insertion layer and the collector interconnection portion are formed, wherein the second collector layer is connected to the collector interconnection portion; and
forming the first collector layer of the first conductivity type through photolithography and ion injection on the second collector layer.

14. The method for preparing a reverse conducting IGBT power device according to any one of claims 11 to 13, wherein the original substrate is made of Si, SiC, GaAs, or GaN.

15. An electronic device (1000), comprising at least one reverse conducting IGBT power device (100) according to any one of claims 1 to 9.
